# EUROPEAN PATENT APPLICATION

(11) **EP 2 096 744 A1**
(43) Date of publication of application: **02.09.2009**
(21) Application number: 08152028.0
(22) Date of filing: 27.02.2008
(51) Int. Cl.: H02M 3/158, H02P 7/29, H03K 17/16, H03K 17/687

(54) **H-Bridge circuit and method for operating such circuit**

(71) Applicant: IEE INTERNATIONAL ELECTRONICS & ENGINEERING S.A., 6468 Echternach (LU)
(72) Inventor: Lamesch, Laurent, 4881 Lamadelaine (LU)
(74) Representative: Office Freylinger

(57) **Abstract**

A H-bridge circuit for supplying a load with a defined current is disclosed, comprising a first transistor for coupling a first terminal of said load to a positive potential of a power source; a second transistor for coupling said first terminal of said load to a negative potential of said power source; a third transistor for coupling a second terminal of said load to said positive potential of said power source; and a fourth transistor for coupling said second terminal of said load to said negative potential of said power source. The circuit further comprises a current sensing circuitry for sensing a current flowing through said load and for generating a voltage signal representative of said current, and a control circuit for individually controlling the operation of said first, second, third and fourth transistors by respective first, second, third and fourth control signals, said control circuit being configured for operating two transistors of said first, second, third and fourth transistors in switching mode and for operating the remaining two transistors in linear mode. According to the invention, each of said linear mode transistors has a feedback circuit associated therewith, said feedback circuit being operatively coupled to said control circuit and to said current sensing circuitry, said feedback circuit controlling the associated linear mode transistor so that a difference between the voltage signal of said current sensing circuitry and the respective control signal from said control circuit is minimized.

## Description

### Technical field

The present invention generally relates to a H-bridge circuit for driving electrical loads with a defined current and to a method for operating such an H-Bridge circuit in current sourcing mode.

### Background Art

It is well known in the art to use H-bridge circuits for supplying a defined current to a load. One specific method to do so is to use a fully linear H-bridge which has low efficiency. Additionally, the measurement of the actual value of the current into the load and an overall feedback loop to control the current into the load are required.

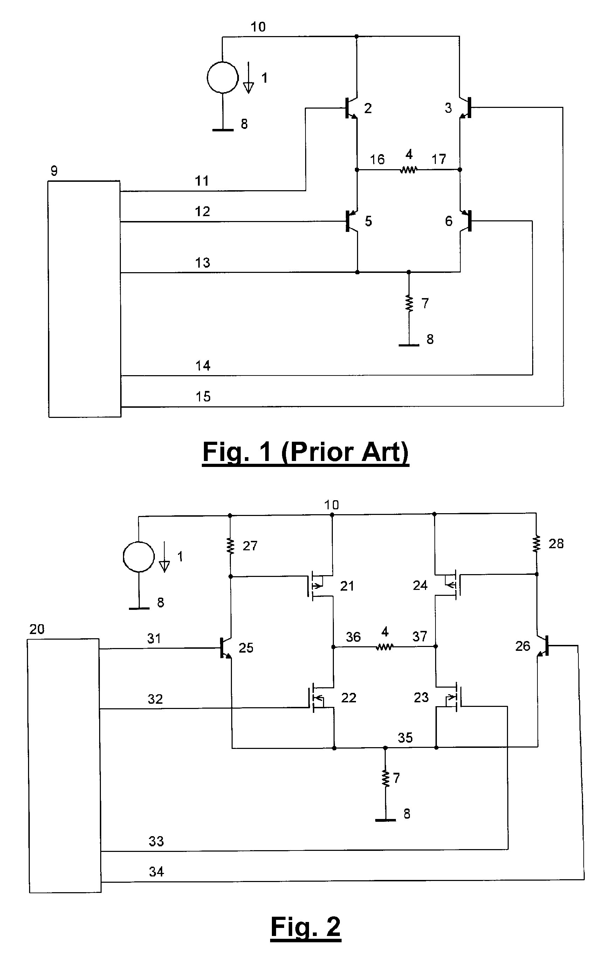

A possible implementation of a H-bridge operating in linear mode is shown in Fig. 1. In this circuit diagram, the different reference numerals denote the following elements:
- 1: a power supply voltage source,
- 2, 3: NPN transistors,
- 4: the load,
- 5, 6: PNP transistors,
- 7: a shunt resistor,
- 8: the circuit ground,
- 9: a control circuit,
- 10: the supply voltage node,
- 11: the control node for transistor 2,
- 12: the control node for transistor 5,
- 13: the feedback node of the load current measurement,
- 14: the control node for transistor 6,
- 15: the control node for transistor 7,
- 16: the left output node of the H-bridge,
- 17: the right output node of the H-bridge.

Bipolar transistors are shown in this figure, but other transistor types, like Mosfet transistors can also be used instead. The load is shown in the circuit diagram as resistor, but other load types, such as complex or non-linear loads may also be used instead.

Transistors 2 and 5, and 3 and 6 each constitute a voltage follower. The control circuit 9 supplies control voltages to the H-bridge in such a way that the transistor bias currents are set correctly, so that the current waveform through the load 4 is substantially equal to the required current waveform, and that the amplitude of the current through the load is substantially equal to the required amplitude. The transistor bias currents are established by the control circuit by setting the differences between the voltages of control nodes 11 and 12, and 14 and 15 respectively to a constant level. The required current waveform is applied to the load by the control circuit by setting the mean of the voltages of the control nodes 11 and 12 to the required waveform, and by setting the mean of the voltages of the control nodes 14 and 15 to the inverted required waveform. In this manner, the right output node of the H-bridge, 17, is always in opposite phase compared to the left output node of the H-bridge, 16. The control circuit 9 also measures the actual value of the current amplitude through the load 4 by measuring the voltage amplitude on feedback node 13, which is the amplitude of the voltage drop through the shunt resistor 7, and thereby substantially equal to the amplitude of the current through the load 4 multiplied by the resistance of shunt resistor 7. A control loop inside the control circuit 9 sets the signal amplitudes on the control nodes 11, 12, 14, 15 in such a way that the required load current amplitude is substantially equal to the desired value.

A large disadvantage of this circuit is that a large minimum voltage drop is required across the transistors 2, 3, 5 and 6, more precisely between supply voltage node 10 and left output node 16, between supply voltage node 10 and right output node 17, between left output node 16 and feedback node 13, and between right output node 17 and feedback node 13. These voltage drops imply that an appreciable amount of power is dissipated in the transistors, which lowers the overall efficiency of the H-bridge circuit.

Another disadvantage of this circuit is that the load current amplitude must be controlled via an overall control loop, which can be complex, and stability problems may arise depending on the load characteristics.

### Technical problem

It is an object of the present invention to provide an H-bridge circuit for supplying a precisely defined current to an electrical load in a more efficient way.

This object is achieved by a H-bridge circuit for supplying a load with a defined current as claimed in claim 1.

### General Description of the Invention

In order to overcome the above-mentioned problem, the present invention proposes a H-bridge circuit for supplying a load with a defined current, comprising a first transistor for coupling a first terminal of said load to a positive potential of a power source; a second transistor for coupling said first terminal of said load to a negative potential of said power source; a third transistor for coupling a second terminal of said load to said positive potential of said power source; and a fourth transistor for coupling said second terminal of said load to said negative potential of said power source. The circuit further comprises a current sensing circuitry for sensing a current flowing through said load and for generating a voltage signal representative of said current, and a control circuit for individually controlling the operation of said first, second, third and fourth transistors by respective first, second, third and fourth control signals, said control circuit being configured for operating two transistors of said first, second, third and fourth transistors in switching mode and for operating the remaining two transistors in linear mode. According to the invention, each of said linear mode transistors has a feedback circuit associated therewith, said feedback circuit being operatively coupled to said control circuit and to said current sensing circuitry, said feedback circuit controlling the associated linear mode transistor so that a difference between the voltage signal of said current sensing circuitry and the respective control signal from said control circuit is minimized.

In contrast to the above described state of the art H-bridge circuits, the present invention operates one half of the H-bridge in switching mode and the other in linear mode. Furthermore, each of the linear mode transistors is controlled by a local feedback loop, which is much more efficient and less complex than the prior art overall control loop for controlling the load current amplitude.

In a preferred embodiment, said feedback circuit comprises a feedback transistor coupled between the gate/base of the associated linear mode transistor and the current sensing circuitry and a resistive element coupled between the gate/base of the associated linear mode transistor and the power source. The base/gate of said feedback transistor is connected to said control circuit for receiving the control signal for the associated linear mode transistor.

The feedback transistor is preferably coupled with its emitter/source to said current sensing circuitry and said control signal for the associated linear mode transistor is substantially equal to the sum of a reference signal representative of the current signal to be supplied by the associated linear mode transistor and the base-emitter voltage drop resp. the gate-source voltage drop of the feedback transistor. The reference signal is e.g. the voltage signal, that the desired current supplied by the associated linear mode transistor generates at the current sensing circuitry.

The feedback transistors are preferably bipolar transistors which are characterized by a more stable operation under varying temperature conditions. On the other hand, the first, second, third and fourth transistors are preferably MOSFET transistors which are known for their faster switching and their reduced power consumption.

In a very simple embodiment, the current sensing circuitry comprises a shunt resistor coupled between the first and the third transistor and said positive potential of said power source or between the second and the fourth transistor and said negative potential of said power source, such that the current flowing though said load produces a potential difference across said shunt resistor.

### Brief Description of the Drawings

A preferred embodiment of the invention will now be described, by way of example, with reference to the accompanying drawings in which:
Fig. 1 shows a circuit diagram of a prior art H-bridge circuit ;
Fig. 2 shows a circuit diagram of an embodiment of a H-bridge circuit according to the present invention;
Fig. 3 illustrates the different signals during the operation of the circuit shown in Fig.2.

### Description of Preferred Embodiments

A possible implementation of a H-bridge in accordance with the present invention is shown in Fig. 2. In this circuit diagram, the different reference numerals denote the following elements:
- 1: a power supply voltage source,
- 4: the load,
- 7: a shunt resistor,
- 8: the circuit ground,
- 10: the supply voltage node,
- 20: a control circuit,
- 21, 24: P-channel Mosfets,
- 22, 23: N-channel Mosfets,
- 25, 26: NPN transistors,
- 27, 28: pullup resistors,
- 31: the control node for transistor 25,
- 32: the control node for Mosfet 22,
- 33: the control node for Mosfet 23,
- 34: the control node for transistor 26,
- 35: the upper node of shunt resistor 7.

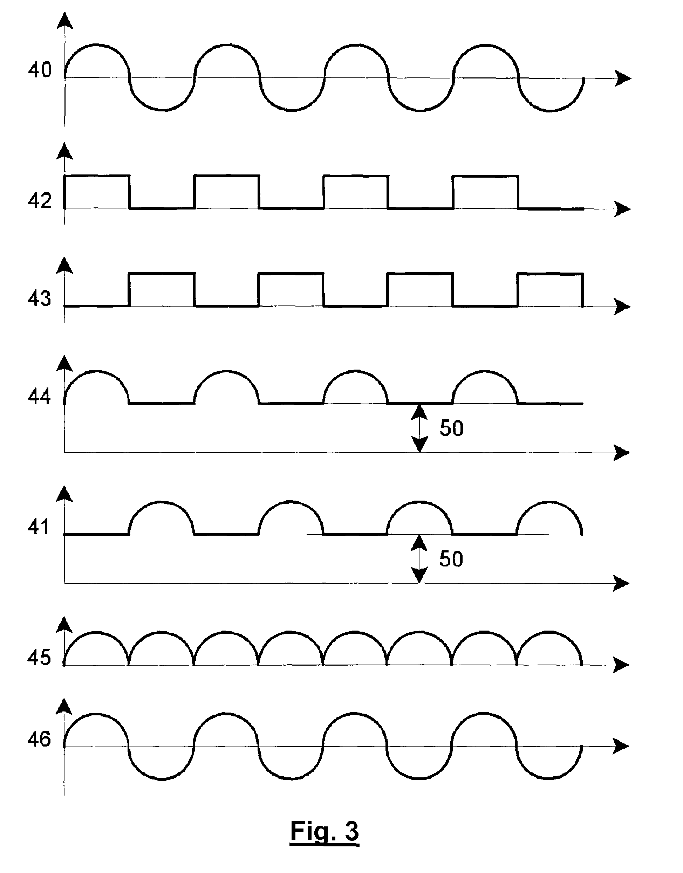

The curves in Fig.3 illustrate the different signals during the operation of the circuit shown in Fig.2.
- 40: an example of the desired current waveform,
- 41: the waveform of the voltage on control node 31,
- 42: the waveform of the voltage on control node 32,
- 43: the waveform of the voltage on control node 33,
- 44: the waveform of the voltage on control node 34,

- 45: the waveform of the voltage on upper node 35 of shunt resistor 7,
- 46: the current through the load 4,
- 50: a voltage which is substantially equal to the base-emitter voltage drop (Vbe) of transistors 25 and 26 (e.g. ≈0,7 V for bipolar transistors).

Four periods of the relevant signals in Fig.2 are shown in Fig.3. The signals shown in Fig.3 are only an illustrative example for signals which may occur in an implementation of the circuit shown in Fig.2. When a different load current signal is required, the signal forms shown in Fig.3 will be different.

The control circuit 9 transforms the required signal 40 into the four control signals 41, 42, 43, 44 on control nodes 31, 32, 33, 34 respectively. The control circuit needs not necessarily transform the required signal into the control signals, it can also generate the control signals individually from scratch.

Control signal 42 is high whenever the required signal 40 is positive and low otherwise. Control signal 43 is high whenever the required signal 40 is negative and low otherwise.

Control signal 44 is substantially equal to the sum of the required signal 40 and the base-emitter voltage drop 50 (Vbe) of transistors 25 and 26 during the first half of each period, and substantially equal to the base-emitter voltage drop 50 (Vbe) of transistors 25 and 26 during the second half of each period.

Control signal 41 is substantially equal to the sum of the required signal 40 and the base-emitter voltage drop 50 (Vbe) of transistors 25 and 26 during the second half of each of its periods, and substantially equal to the base-emitter voltage drop 50 (Vbe) of transistors 25 and 26 during the first half of each of its periods.

In the circuit of Fig.2, transistors 21 and 24 are operated as controlled current sources, while transistors 22 and 23 are operated as switches with low switch voltage drop.

During the first half period of the required signal 40, the control signal 42 is set to high level, thereby switching on transistor 22. Control signal 43 is low, thereby switching off transistor 23. Control signal 44 is substantially equal to the sum of the required signal 40 and the base-emitter voltage drop 50 (Vbe) of transistor 26. Control signal 41 is substantially equal to the base-emitter voltage drop 50 (Vbe) of transistor 26. Transistors 24, 22 and 26, load 4 and shunt resistor 7 form a first load current control loop during the first half of each period. The supply current flows from the power supply voltage source 1 through transistor 24, the load 4, transistor 22, shunt resistor 7, into circuit ground 8 and back into supply voltage source 1. The aforementioned first load current control loop keeps the current through the load substantially equal to the required signal 40 divided by the resistance of the shunt resistor 7 in the following way: the current through the load also flows through the shunt resistor 7, thereby creating a voltage on the upper node 35 of the shunt resistor 7, which is equal to the current through the load multiplied by the resistance of shunt resistance 7. As long as for example this voltage is lower than the voltage 44 on the control node 34 minus the base-emitter voltage drop 50 (Vbe) of transistor 26, transistor 26 draws a current into its collector. This current flows through the pullup resistor 28, thereby pulling down the voltage on the gate of transistor 24, and thereby increasing the current flowing through transistor 24. This same current flows from the supply voltage node 10 into the load 4, thereby increasing the current through shunt resistor 7, and thereby increasing the voltage on the upper node 35 of the shunt resistor 7. In summary, the first control loop increases the current through the load until the voltage on the upper node 35 of the shunt resistor 7, signal 45 in Fig.3, is substantially equal to the voltage on the control node 34 minus the base-emitter voltage drop 50 (Vbe) of transistor 26, which is substantially equal to the required signal 40.

If on the other hand the voltage on the upper node 35 of the shunt resistor 7 is higher than the voltage 44 on the control node 34 minus the base-emitter voltage drop 50 (Vbe) of transistor 26, transistor 26 is closed and draws no current into its collector. Hence there is no voltage drop across pullup resistor 28, so that transistor 24 closes. The first control loop thereby controls the current through the load, signal 46 in Fig.3, in such a way that it is equal to the required signal divided by the resistance of shunt resistor 7 during the first half of each period.

During the second half period of the required signal 40, the control signal 43 is set to high level, thereby switching on transistor 23. Control signal 42 is low, thereby switching off transistor 22. Control signal 41 is substantially equal to the sum of the required signal 40 and the base-emitter voltage drop 50 (Vbe) of transistor 25. Control signal 44 is substantially equal to the base-emitter voltage drop 50 (Vbe) of transistor 25. Transistors 21, 23 and 25, load 4 and shunt resistor 7 form a second load current control loop during the second half of each period. The supply current flows from the power supply voltage source 1 through transistor 21, the load 4, transistor 23, shunt resistor 7, into circuit ground 8 and back into supply voltage source 1. Similarly to the first control loop, the second control loop controls the current through the load, signal 46 in Fig.3, in such a way that it is substantially equal to the required signal divided by the resistance of shunt resistor 7 during the second half of each period

Finally, as the two control loops operate alternatively, the current through the load 4 is consequently always substantially equal to the required signal divided by the resistance of shunt resistor 7.

It is obvious that the control signal 44 needs not to be kept substantially equal to the base-emitter voltage drop 50 (Vbe) of transistor 26 during the first half of each period, it is sufficient that the voltage level of control signal 44 is sufficiently low so that transistor 26 is kept off during the first half of each period. Also, it is obvious that the control signal 41 needs not to be kept substantially equal to the base-emitter voltage drop 50 (Vbe) of transistor 25 during the first half of each period, it is sufficient that the voltage level of control signal 41 is sufficiently low so that transistor 25 is kept off during the first half of each period.

The required voltage level shift of one base-emitter voltage drop (Vbe) of transistors 25 and 26, between the required signal and the control signal 44 during the first half of each period, and between the required signal and the control signal 41 during the second half of each period can easily be implemented by using one additional transistor for each of the level shifts, for example a PNP bipolar transistor configured as voltage follower.

It will be noted, that instead of the bipolar transistors shown in fig. 2 other transistor types, like Mosfet transistors can be used instead, and instead of the Mosfet transistors shown in this figure other transistor types, like bipolar transistors can be used instead. Furthermore the load is shown in the circuit diagram as resistor, but other load types, such as complex or non-linear loads may also be used instead.
The pullup resistors 27 and 28 can also be replaced by current sources.

## Claims

1. A H-bridge circuit for supplying a load with a defined current, comprising
a first transistor for coupling a first terminal of said load to a positive potential of a power source;
a second transistor for coupling said first terminal of said load to a negative potential of said power source;
a third transistor for coupling a second terminal of said load to said positive potential of said power source;
a fourth transistor for coupling said second terminal of said load to said negative potential of said power source;
a current sensing circuitry for sensing a current flowing through said load and for generating a voltage signal representative of said current,
and a control circuit for individually controlling the operation of said first, second, third and fourth transistors by respective first, second, third and fourth control signals, said control circuit being configured for operating two transistors of said first, second, third and fourth transistors in switching mode and for operating the remaining two transistors in linear mode;
**characterized in that**
each of said linear mode transistors has a feedback circuit associated therewith, said feedback circuit being operatively coupled to said control circuit and to said current sensing circuitry, said feedback circuit controlling the associated linear mode transistor so that a difference between the voltage signal of said current sensing circuitry and the respective control signal from said control circuit is minimized.

2. The H-bridge circuit as claimed in claim 1, wherein said feedback circuit comprises a feedback transistor coupled between the gate/base of the associated linear mode transistor and the current sensing circuitry and a resistive element coupled between the gate/base of the associated linear mode transistor and the power source, and wherein a base/gate of said feedback transistor is connected to said control circuit for receiving the control signal for the associated linear mode transistor.

3. The H-bridge circuit as claimed in claim 2, wherein said feedback transistor is coupled with its emitter/source to said current sensing circuitry and wherein said control signal for the associated linear mode transistor is substantially equal to the sum of a reference signal representative of the current signal to be supplied by the associated linear mode transistor and the base-emitter voltage drop resp. the gate-source voltage drop of the feedback transistor.

4. The H-bridge circuit as claimed in any one of claims 2 to 3, wherein said feedback transistors are bipolar transistors.

5. The H-bridge circuit as claimed in any one of claims 1 to 4, wherein said first, second, third and fourth transistors are MOSFET transistors.

6. The H-bridge circuit as claimed in any one of claims 1 to 5, wherein said current sensing circuitry comprises a shunt resistor coupled between the first and the third transistor and said positive potential of said power source or between the second and the fourth transistor and said negative potential of said power source, such that the current flowing though said load produces a potential difference across said shunt resistor.
